# EUROPÄISCHE PATENTSCHRIFT

(11) **EP 1 122 699 B1**
(45) Veröffentlichungstag und Bekanntmachung des Hinweises auf die Patenterteilung: **02.07.2003**
(21) Anmeldenummer: 01101209.3
(22) Anmeldetag: 18.01.2001
(51) Int. Cl.: G08B 13/19

(54) **Multifunktionsmodul eines Passiv-Infrarot-Bewegungsmelders**
Multi-functional module of a passive infrared movement detecter
Module multifonctionnel d'un détecteur passif de mouvement infrarouge

(30) Priorität: 04.02.2000 DE 10005026
(43) Veröffentlichungstag der Anmeldung: 08.08.2001
(73) Patentinhaber: ABB PATENT GmbH, 68526 Ladenburg (DE)
(72) Erfinder: Vogt, Friedrich, 58579 Schalksmühle (DE); Zapp, Robert, 58579 Schalksmühle (DE); Neumann, Wolfgang, 58849 Herscheid (DE); Schmidt, Karsten, 42477 Radevormwald (DE)
(74) Vertreter: Miller, Toivo

(56) Entgegenhaltungen:
- US-A- 4 644 164

## Beschreibung

Die Erfindung bezieht sich auf ein Multifunktionsmodul eines Passiv-Infrarot-Bewegungsmelders gemäß dem Oberbegriff des Anspruchs 1.

Bei einem Passiv-Infrarot-Bewegungsmelder müssen die Infrarotdetektoren - nachfolgend auch als Sensoren bezeichnet - in einer bestimmten Lage zu den im Gehäuse des Bewegungsmelders eingebetteten Linsensystemen positioniert werden. Üblicherweise geschieht dies über einen Adapter bzw. ein Multifunktionsmodul, in welches mit IR-Sensoren (Infrarot-Sensoren bzw. allgemein Sensoren) und elektrischen/elektronischen Bauelementen (insbesondere Widerständen) bestückte Leiterplatten eingesteckt sind.

Zur Erfassung von Bereichen, die auf Grund der Einbaulage der Sensoren nicht direkt durch die Sensoren abgedeckt werden können, werden üblicherweise Spiegelelemente am Multifunktionsmodul befestigt, vorzugsweise verrastet. Diese Spiegel bestehen vielfach aus galvanisierten Kunststoffteilen.

Das komplette, aus einem Kunststoffhalter, Leiterplatten, Sensoren, elektrischen/elektronischen Bauelementen und Spiegeln bestehende Multifunktionsmodul wird auf einer Hauptleiterplatte montiert, welche im Gehäuse des Bewegungsmelders montiert (verrastet) ist und auf der sich die übrige Elektronik befindet.

Aus der DE 198 21 302 A1 ist ein in der vorstehend erläuterten Art und Weise aufgebauter Passiv-Infrarot-Bewegungsmelder bekannt, der eine Hauptleiterplatte enthält, die mit einem Multifunktionsmodul verbunden ist, das aus einem Adapter mit darin eingesteckten Detektorleiterplatten besteht und mit aufsteckbaren Spiegelanordnungen ergänzbar ist.

Nachteilig bei dieser bekannten Bauweise eines Passiv-Infrarot-Bewegungsmelders ist die relativ hohe Anzahl der erforderlichen Einzelteile des Multifunktionsmoduls sowie der damit verbundene hohe Fertigungsaufwand und Montageaufwand. Im bekannten Fall ist die getrennte Herstellung eines Kunststoffhalters (mittels eines Kunststoffspritzwerkzeuges), mindestens einer Detektorleiterplatte (für jeden der eingesetzten Sensoren) und mindestens eines Spiegels sowie die Montage dieser Baukomponenten notwendig.

Ein Passiv-Infrarot Bewegungs melders mit einem spiegel auf einer Leiterplatte ist aus US 4,644,164 bekannt.

Der Erfindung liegt die Aufgabe zugrunde, ein Multifunktionsmodul eines Passiv-Infrarot-Bewegungsmelders der eingangs genannten Art mit vereinfachtem Aufbau anzugeben.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß das Multifunktionsmodul aus sehr wenig Einzelteilen besteht, sehr wenig Fertigungsschritte benötigt und aufgrund der wenigen notwendigen Montageschritte sehr montagefreundlich ist. Dies reduziert die Investitionskosten (beispielsweise die Kosten für Werkzeuge zur Herstellung der Einzelteile) und die Montagekosten.

Die Einbaulage der Spiegel in Relation zum Sensor und zum Linsensystem des Gehäuses ist sehr exakt reproduzierbar, da keine toleranzbehafteten Einzelteile mit sich summierenden Einzeltoleranzen zu montieren sind. Hierdurch ist die Erfassungscharakteristik des Passiv-Infrarot-Bewegungsmelders sehr gut projektierbar und reproduzierbar. Das Multifunktionsmodul übernimmt die Funktionen der bislang getrennt gefertigten, in einen Kunststoffhalter eingeschobenen Leiterplatten (elektrische Funktion), die Funktionen der bislang getrennt gefertigten, am Kunststoffhalter montierten Spiegel (optische Funktion) und die Funktionen dieses Kunststoffhalters (mechanische Funktion) in einem einzigen Teil.

Weitere Vorteile sind aus der nachstehenden Beschreibung ersichtlich.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:
- Fig.1: eine perspektivische Ansicht eines aus einer ersten Komponente aufgebauten Teils des Multifunktionsmoduls,
- Fig. 2: eine perspektivische Ansicht eines aus einer ersten und einer zweiten Komponente aufgebauten Multifunktionsmoduls,
- Fig. 3: eine perspektivische Ansicht eines mit elektrischen/elektronischen Bauelementen und Sensoren bestückten Multifunktionsmoduls.
- Fig. 4: die einzelnen Schritte zur Herstellung des Multifunktionsmoduls.

Die Gestaltung des Multifunktionsmoduls beruht auf der Idee, ein Multifunktionsmodul zu schaffen, das neben der üblichen mechanischen Tragefunktion möglichst viele Funktionen der bisher üblicherweise eingesetzten zusätzlichen Einzelteile übernimmt.

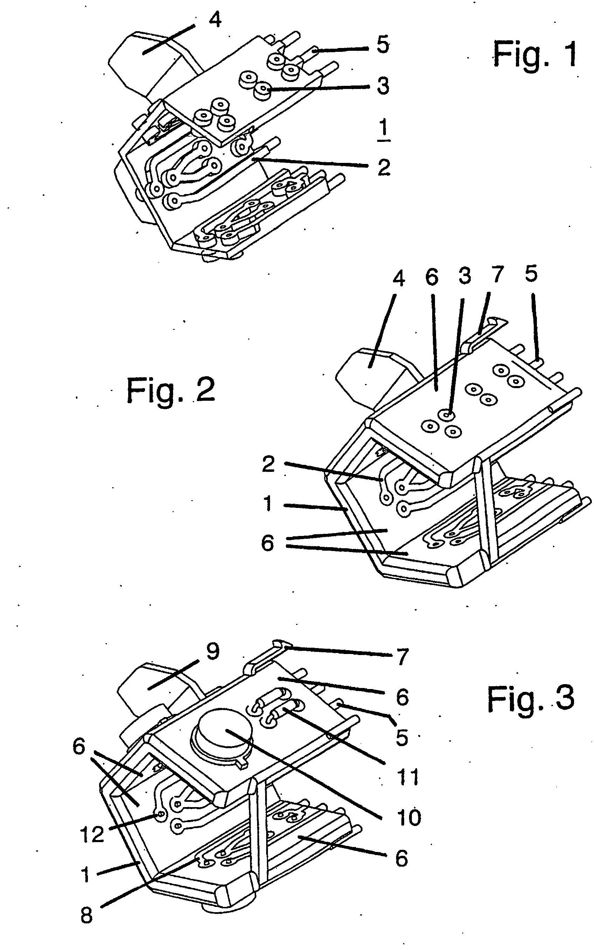

In Fig. 1 ist eine perspektivische Ansicht eines aus einer ersten Kömponente aufgebauten, in Kunststoff-Spritzgußtechnik produzierten Teils des Multifunktionsmoduls dargestellt. Die erste Komponente 1 ist einstückig in Form von vier mit vorgegebenem Winkel aneinandergefügten Platten ausgebildet und besteht aus einem galvanisierbaren Kunststoff. Jede Platte ist zur Montage eines Sensors (siehe Ziffer 10 in Fig. 3) bestimmt, so daß sich die zwischen den Platten vorzugebenden Winkel nach den Erfassungsbereichen dieser einzelnen Sensoren bemessen, um derart einen Passiv-Infrarot-Bewegungsmelder mit dem gewünschten großen Erfassungsbereich zu realisieren.

Die Platten der ersten Komponente 1 sind jeweils mit
- Rippen 2 zur Bildung von Leiterbahnen (Siehe Ziffer 8 in Fig. 3),
- Erhebungen 3 zur Bildung von Anschlußaugen (siehe Ziffer 12 in Fig. 3) für die Verlötung von diskreten elektrischen/elektronischen Bauelementen (siehe Ziffer 11 in Fig. 3) und die Verlötung von Sensoren,
- Zapfen 5 zur Bildung von Kontaktstiften an den Unterseiten und
- Auskragungen 4 zur Bildung von Spiegeln (siehe Ziffer in Fig. 3) versehen. Die Spiegel ermöglichen die Erfassung von Bereichen, die für die Sensoren nicht erfaßbar sind.

In Fig. 2 ist eine perspektivische Ansicht eines aus einer ersten und einer zweiten Komponente aufgebauten Multifunktionsmoduls dargestellt. Wie zu erkennen ist, sind die einzelnen Platten der ersten Komponente 1 in Kunststoff-Spritzgußtechnik mit einer zweiten Komponente 6 umspritzt, wobei diese zweite Komponente 6 aus einem elektrisch isolierenden, nicht galvanisierbaren Kunststoff besteht. Die Oberflächen der Rippen 2, der Erhebungen 3, der Auskragungen 4 und die Zapfen 5 werden nicht mit der zweiten Komponente 6 bedeckt. Mit Hilfe der zweiten Komponente 6 werden Rastzungen 7 an den Unterseiten der Platten sowie Stabilisierungsbrücken (nicht beziffert) zwischen den beiden endseitigen Platten gebildet.

In Fig. 3 ist eine perspektivische Ansicht eines mit elektrischen/elektronischen Bauelementen und Sensoren bestückten, aus den beiden Komponenten 1, 6 aufgebauten Multifunktionsmoduls dargestellt. Die beiden Komponenten 1, 6 des Multifunktionsmoduls dienen gleichzeitig als Schaltungs- und Bauteilträger. Die Anschlußdrähte der Sensoren 10 und der diskreten elektrischen/elektronischen Bauelemente 11 sind durch die Bohrungen in den Anschlußaugen 12 gesteckt und mit den Anschlußaugen bzw. den hiermit verbundenen Leiterbahnen 8 verlötet. Das derart fertiggestellte Muttifunktionsmodul wird auf einer Hauptleiterplatte des Passiv-Infrarot-Bewegungsmelders montiert, wobei die mechanische Befestigung über die Rastzungen 7 und der elektrische Anschluß an die Leiterbahnen der Hauptleiterplatte über die als Kontaktstifte ausgebildeten Zapfen 5 erfolgt.

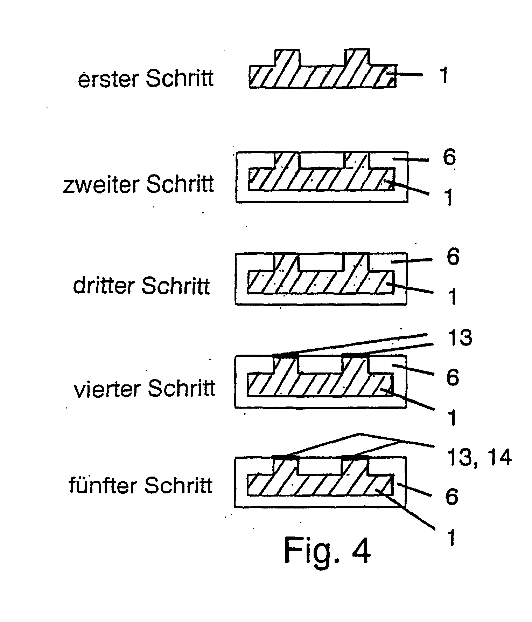

In Fig. 4 sind die einzelnen Schritte zur Herstellung des Multifunktionsmoduls dargestellt. Die Herstellung erfolgt vorzugsweise in MID-Technik (Molded Interconnect Devices) und zwar speziell in Zweikomponentenspritzguß-Technik. Dieses spezielle MID-Hersteliungsverfahren ermöglicht eine hohe Gestaltungsfreiheit, eine Durchkontaktierung ohne zusätzliche Maßnahmen und eine hohe Flexibilität bezüglich des Schichtaufbaues, wobei die Effizienz des Herstellungsprozesses sehr hoch ist.

In einzelnen wird zur Herstellung des Multifunktionsmoduls in einem ersten Schritt die erste Komponente 1 aus einem galvanisierbarem Kunststoff gespritzt ("erster Schuß"). In einem zweiten Schritt erfolgt die teilweise Umhüllung der Komponente 1 mit der zweiten Komponente 6 aus einem nicht galvanisierbarem, elektrisch isolierendem Kunststoff ("zweiter Schuß"). Die zweite Komponente 6 dient insbesondere zur Gewährleistung eines mechanisch robusten Aufbaus des Multifunktionsmoduls und zu einer elektrischen Isolierung des Multifunktionsmoduls zu diskreten elektrischen/elektronischen Bauelementen und zum Gehäuse bzw. weiteren Baukomponenten des Passiv-Infrarot-Bewegungsmelders.

In einem dritten Schritt erfolgt eine Oberflächenaktivierung der Komponente 1 aus dem galvanisierbarem Kunststoff. In einem vierten Schritt erfolgt eine Metallisierung der freiliegenden Bereiche der Komponente 1 aus dem galvanisierbarem Kunststoff durch Aufbringung einer ersten Metallschicht 13 (Grundmetallisierung). In einem fünften Schritt erfolgt eine Oberflächenveredelung durch Aufbringung einer zweiten Metallschicht 14 mit sehr guter elektrischer Leitfähigkeit und sehr guter Wärmestrahlung-Reflexionsfähigkeit auf die Grundmetallisierung zur Schaffung der Anschlußaugen 12, Kontaktstifte 5, Leiterbahnen 8 und Spiegel 9. Der große Vorteil der angewandten Technik liegt also auch darin, daß ein- und derselbe Galvanikprozeß sowohl zur Erzeugung der elektrischen Leitfähigkeit der Leiterbahnen, Anschlußaugen und Zapfen als auch zur Erzeugung der direkt angeformten Spiegelflächen genutzt wird.

## Patentansprüche

1. Multifunktionsmodul eines Passiv-Infrarot-Bewegungsmetders, **dadurch gekennzeichnet, daß** das Multifunktionsmodul aus zwei Hauptkomponenten aufgebaut ist, nämlich einer ersten Komponente (1) aus einem galvanisierbaren Kunststoff und einer zweiten Komponente (6) aus einem nicht galvanisierbaren, elektrisch isolierendem Kunststoff, wobei die erste Komponente (1) in Verbindung mit mindestens einer aufgebrachten Metallschicht (13, 14) zur Bildung mindestens eines Spiegels (9) sowie zur Bildung von integrierten Leiterbahnen (8) und integrierten Anschlußaugen (12) für den Anschluß diskreter elektrischer/elektronischer Bauelemente (11) sowie Sensoren (10) dient und die zweite Komponente (6) den mechanisch robusten Aufbau und die elektrische Isolierung des Multifunktionsmoduls gewährleistet.

2. Multifunktionsmodul nach Anspruch 1, **dadurch gekennzeichnet, daß** die erste Komponente (1) am Ort des zu bildenden mindestens einen Spiegels (9) als Auskragung (4) geformt ist.

3. Multifunktionsmodul nach Anspruch 1 und/oder 2, **dadurch gekennzeichnet, daß** die erste Komponente (1) im Endbereich des Multifunktionsmoduls zapfenförmig geformt ist, um derart mit mindestens einer aufgebrachten Metallschicht (13, 14) Kontaktstifte zu bilden, welche mit einer Hauptleiterplatte verlötbar sind.

4. Multifunktionsmodul nach mindestens einem der vorstehenden Ansprüche, **dadurch gekennzeichnet, daß** mittels der zweiten Komponente (6) Rastzungen (7) gebildet sind.

## Claims

1. Multi-functional module of a passive infrared movement detector, **characterized in that** the multi-functional module is constructed from two main components, that is a first component (1) of an electroplatable plastic and a second component (6) of an electrically insulating plastic which cannot be electroplated, the first component (1) serving together with at least one applied metal layer (13, 14) for forming at least one mirror (9) and also for forming integrated conductor tracks (8) and integrated terminal lugs (12) for the connection of discrete electrical/electronic components (11) and sensors (10), and the second component (6) ensuring the mechanically robust construction and electrical insulation of the multi-functional module.

2. Multi-functional module according to Claim 1,
**characterized in that** the first component (1) is formed as a projection (4) at the location of the at least one mirror (9) to be formed.

3. Multi-functional module according to Claim 1 and/or 2, **characterized in that** the first component (1) is formed in a stub-shaped manner in the end region of the multi-functional module, in order to form in this way, with at least one applied metal layer (13, 14), contact pins which can be soldered to a main printed circuit board.

4. Multi-functional module according to at least one of the preceding claims, **characterized in that** clip-in tongues (7) are formed by means of the second component (6).

## Revendications

1. Module multifonction d'un détecteur de mouvement passif infrarouge, **caractérisé en ce que** le module multifonction est constitué de deux composants principaux, à savoir d'un premier composant (1) en matière plastique susceptible d'être galvanisée et d'un deuxième composant (6) en une matière plastique électriquement isolante, ne pouvant pas être galvanisée, le premier composant (1), en relation avec au moins une couche métallique (13, 14) appliquée, servant à réaliser au moins un miroir (9), des pistes conductrices (8) intégrées et des pastilles de connexion (12) intégrées, en vue de la connexion d'éléments électriques/électroniques (11) distincts, ainsi que des détecteurs (10), et le deuxième composant (6) assurant une structure mécaniquement robuste et l'isolation électrique du module multifonction.

2. Module multifonction selon la revendication 1, **caractérisée en ce que** le premier composant (1) est réalisé sous forme d'élément en porte-à-faux (4), à l'endroit où doit être réalisé le miroir (9) au nombre d'au moins un.

3. Module multifonction selon la revendication 1 et/ou 2, **caractérisée en ce que**, dans la zone d'extrémité du module multifonction, le premier composant (1) est conformé en doigt pour constituer ainsi, avec au moins une couche métallique (13, 14) appliquée, des broches de contact qui peuvent être soudées à une carte à circuit imprimé principale.

4. Module multifonction selon au moins une des revendications précédentes, **caractérisé en ce que** des nez d'encliquetage (7) sont formés à l'aide du deuxième composant (6).
